# EUROPEAN PATENT SPECIFICATION

(11) **EP 0 752 741 B1**
(45) Date of publication and mention of the grant of the patent: **21.11.2001**
(21) Application number: 96401497.1
(22) Date of filing: 08.07.1996
(51) Int. Cl.: H01R 12/22, H01R 12/16

(54) **Impedance controlled interconnection device**
Verbindungsvorrichtung mit gesteuertem Impedanzverhalten
Dispositf d'interconnexion à impédance contrôlé

(30) Priority: 07.07.1995 US 942
(43) Date of publication of application: 08.01.1997
(73) Proprietor: JOHNSTECH INTERNATIONAL CORPORATION, Minneapolis, Minnesota 55413 (US)
(72) Inventor: Johnson, David A., Wayzata, Minnesota 55447 (US); Kline, Eric V., Stillwater, Minnesota 55082 (US)
(74) Representative: Joly, Jean-Jacques

(56) References cited:
- US-A- 4 961 709
- US-A- 5 069 629
- US-A- 5 169 320
- US-A- 5 171 290
- US-A- 5 302 923

## Description

### Technical Field

The present invention deals broadly with the field of devices for interconnecting electrical contacts. More narrowly, however, the invention is related to technology for inter-connecting a plurality of corresponding terminals by means of an electrical conductor between an integrated circuit device and a printed circuit board or between two printed circuit boards. The device is particularly useful for interfacing an integrated circuit with a tester, including a printed circuit board, during the manufacturing process to assure operativeness. The preferred embodiments of the present invention are directed to means for controlling the impedance and/or providing shielding to the interconnection between devices.

### Background of the Invention

Devices and methods for effecting electrical interconnection between two conductors are generally known. A specialized area of such interconnection has been recently expanding with the advent of integrated circuit technology. For example, in the manufacturing process for fabricating integrated circuit devices, each integrated circuit must be tested for operativeness. Thus, each lead of an integrated circuit device must be interconnected with a tester apparatus, wherein the tester apparatus may determine the functionality and performance of the corresponding integrated circuit device.

During such testing, an integrated circuit device is typically placed into an interconnect device (such as a test socket). The interconnect device interconnects each lead of the integrated circuit with a corresponding terminal of a printed circuit board. This may be accomplished with a number of contacts within the interconnect device. A tester apparatus is then electrically coupled to the printed circuit board such that the signals provided to each lead of the integrated circuit may be controlled and/or observed by the tester apparatus.

A further specialized area of interconnecting electrical contacts focuses on the interconnection of two printed circuit boards. These interconnections have applications utilizing insertable boards, such as memory cards, or multi-chip boards which are highly miniaturized and integrated.

Several technologies for packaging an integrated circuit chip into an semi-conductor package have been developed. These may be generally categorized as pin grid array (PGA) systems and leaded semi-conductor devices. The leaded semi-conductor devices include plastic leaded chip carriers (PLCC), dual in-line packages (DIP) and Quad Flat Pack (QFP). Each packaging type requires a particular array of leads to be interconnected with a printed circuit board.

A number of methods for connecting integrated circuits, such as PGA devices, with a printed circuit board are known. It is believed that limitations to these systems are the contact length and the usual requirement of mounting the contacts in through-holes located in a printed circuit board. The contact and through-hole mounting limits the mounting speed of the semi-conductor device while inducing discontinuities and impedance which cause signal reflections back to the source. Further, the design causes high lead inductance and thus problems with power decoupling and may result in cross-talk with closely adjacent signal lines.

Johnson recently disclosed in U.S. Patents No. 5,069,629 (issued December 3, 1991) and No. 5,207,584 (issued May 4, 1993) electrical interconnect contact systems which are directed to addressing both mechanical and electrical considerations of such systems.

The disclosures of Johnson are directed to an interconnect device which comprises a generally planar contact which is received within one or more slots of a housing. In one embodiment, each contact is of a generally S-shaped design and supported at two locations (the hook portions of the S) by a rigid first element and an elastomeric second element. As disclosed, the Johnson electrical interconnect provides a wiping action which enables a good interface to be accomplished between the contact and the lead of the integrated circuit, and between the contact and terminals on a printed circuit board. Further, Johnson discloses an electrical contact that can sustain high operating speeds, and provides a very short path of connection. Such a contact may have low inductance and low resistance, thereby minimizing the impedance of the contact.

In recent years, the number of leads which may extend from one of the above referenced semi-conductor packages has substantially increased. Integrated circuit technology has allowed the integration of several complex circuits onto a single integrated circuit. Often, hundreds of thousands of gates may be incorporated into a single chip. A consequence of such integration is often a requirement that many input/output leads must extend from a corresponding semi-conductor package. To limit the overall dimensions of the semi-conductor package, the spacing between leads of many of the above referenced semi-conductor packages has decreased. As a result thereof, the spacing between the contacts of a corresponding interconnect device has also decreased.

The decrease in spacing between contacts of an interconnect device has necessarily increased the capacitance therebetween. Thus, a signal on a first contact of an interconnect device may affect the signal on a second contact of the interconnect device. This phenomenon is known as cross-talk. Cross-talk increases the noise on a contact, and thus adversely affects the reliability of the interconnect system.

Electromagnetic Interference (EMI) is another source of noise which reduces the reliability of interconnect systems. Typically, a low background level of EMI is present in the environment. Other, more obtrusive sources of EMI included IC testers, computers, test equipment, cellular phones, television and radio signals, etc. All of these sources of EMI should be considered when testing higher performance integrated circuits.

Another consideration of interconnect devices is the impedance provided by the corresponding contacts. It is recognized that the interconnect path between, for example, a semi-conductor package lead and a terminal on a printed circuit board, should have a relatively high and stable bandwidth across all applicable frequencies. That is, not only should the impedance of the interconnect system be minimized as disclosed in Johnson, but the impedance should also be controlled such that a relatively flat bandpass over all applicable frequencies exists.

To achieve a stable bandpass, it is often important to have a contact which provides impedance matching between a corresponding input of an integrated circuit and the corresponding driver. For example, if a tester is driving an input of an integrated circuit device via an interconnect device, it may be important for the interconnect device to provide an impedance such that the impedance of the driver matches the input impedance of the integrated circuit. Since the input impedance of the integrated circuit is often fixed, the impedance of the interconnect device may be used to correct for any impedance mismatch between the driver and the integrated circuit. Impedance matching may be important to minimize reflections and other noise mechanisms which may reduce the reliability and accuracy of the corresponding system.

Accordingly, a need exists for an improved electrical interconnect system to be utilized for interconnecting integrated circuit devices with printed circuit boards or for interconnecting multiple printed circuit boards. The interconnecting device should provide shielding for both cross-talk and EMI. The interconnect device should also allow the user to control and/or select the impedance for each contact provided therein.

There is known from document US-A-5 302 923 an interconnection plate assembly specifically designed for high-frequency signal paths. The interconnection is provided with through-holes which each receive a pin assembly forming a transmission line structure. The pin assembly comprises an insulator sleeve and a conductor pin having two protrusions projecting at respective surfaces of the plate and serving as terminal posts.

There is also known from document US-A-4 961 709 a device e.g. for interconnecting circuit boards comprising a conductive housing that is positionable between the circuit boards and provided with openings receiving connector elements. Each connector element is formed as a volute spring for pressing against the respective contact surfaces of the circuit boards. The connectors intended to convey signals are enclosed in dielectric sleeves that fit snugly in the openings.

### Summary of the Invention

The present invention addresses these needs as well as other problems associated with prior art electrical interconnect systems. The present invention provides an interconnect system whereby a number of contacts are shielded from outside sources of electro-magnetic interference by a conductive housing. Further, each of the contacts may be shielded from cross-talk interference between adjacent contacts by conductive ribs extending therebetween. Finally, the impedance of each contact in the interconnect system may be controlled to provide a stable bandpass, and the impedance may be programmable to match, or correct for, the input impedance of a corresponding device.

In an illustrative embodiment, the present invention provides an electrical interconnect between a number of first terminals and a number of second terminals. The present invention may include a housing, a number of contacts, and a number of insulating elements. Both the housing and the contacts are preferable made from a conductive material. The insulating elements may insulate the number of contacts from the housing. By providing an electrically conductive housing, the contacts may be shielded from outside sources of EMI. At the same time, however, because the contacts are electrically isolated from the housing, the contacts may maintain an independent interconnection between the number of first terminals and the number of second terminals.

An addition advantage of the present invention is that the impedance seen by the contacts is stabilized and controllable. In the present invention, a controlled impedance is created between the contacts and the conductive housing. By varying the geometry of the contacts and the insulating element, the impedance between the contacts and the housing can be programmed. This may provide a stable, and controllable, bandpass for the signals passing through the interconnection system.

In addition to the above, the present invention contemplates shielding the upper and lower portions of the contacts that extend above and/or below the conductive housing. It is contemplated that this may be accomplished in a number of ways, including providing a conductive skirt or gasket that is electrically coupled to the housing, and may extend toward the first and/or second terminals. The conductive skirt may shield the upper and/or lower portions of the contacts from electro-magnetic interference from outside sources. In addition, and to shield each of the contacts from cross-talk interference from adjacent contacts, it is contemplated that a number of ribs may be electrically coupled to the housing and may extend between adjacent contact. Selected ones of the number of ribs may extend above and/or below the top and/or bottom surfaces of the housing. The rib extensions may shield the top and/or bottom portions of the contacts from cross-talk interference. Further, when the first or second terminal is a device lead, the rib extensions may shield cross-talk interference between adjacent device leads, and between the device leads and adjacent contacts.

### Brief Description of the Drawings

In the drawings, in which like reference numerals indicate corresponding parts or elements of preferred embodiments of the present invention throughout the several views:
**Figure 1** is a fragmentary perspective view showing a conductor between two parallel plates;
**Figure 2** is a perspective view with some parts cut away showing a first embodiment of the present invention in combination with an integrated circuit and a printed circuit board;
**Figure 3** is a perspective view showing a housing in accordance with the first embodiment of the present invention;
**Figure 4** is a perspective view with some parts cut away showing a second embodiment of the present invention in combination with a printed circuit board;
**Figure 5** is a perspective view with some parts cut away showing a third embodiment of the present invention in combination with a printed circuit board;
**Figure 6** is a perspective view showing a housing in accordance with the fourth embodiment of the present invention;
**Figure 7** is a side elevational view showing a housing in accordance with the first embodiment of the present invention with a wire mesh placed over the top surface thereof;
**Figure 8A** is a perspective view of an S-shaped contact as used in the present invention;
**Figure 8B** is a perspective view of an S-shaped contact as used in the present invention with a predetermined portion removed therefrom;
**Figure 8C** is a perspective view of an S-shaped contact as used in the present invention with a number of predetermined portions removed therefrom;
**Figure 9A** is a perspective view of a sleeve as used in the first embodiment of the present invention with a predetermined portion removed therefrom;
**Figure 9B** is a perspective view of a sleeve as used in the first embodiment of the present invention with a number of predetermined portion removed therefrom; and
**Figure 10** is a perspective view showing a housing in accordance with the first embodiment of the present invention, wherein a number of S-shaped contacts having varying impedance characteristics are preselected and placed within corresponding slots within the housing.

### Detailed Description of the Invention

Detailed embodiments of the present invention are disclosed herein. However, it is to be understood that the disclosed embodiments are merely exemplary of the present invention which may be embodied in various systems. Therefore, specific details disclosed herein are not to be interpreted as limiting, but rather as a basis for the claims and as a representative basis for teaching one of skill in the art to variously practice the invention.

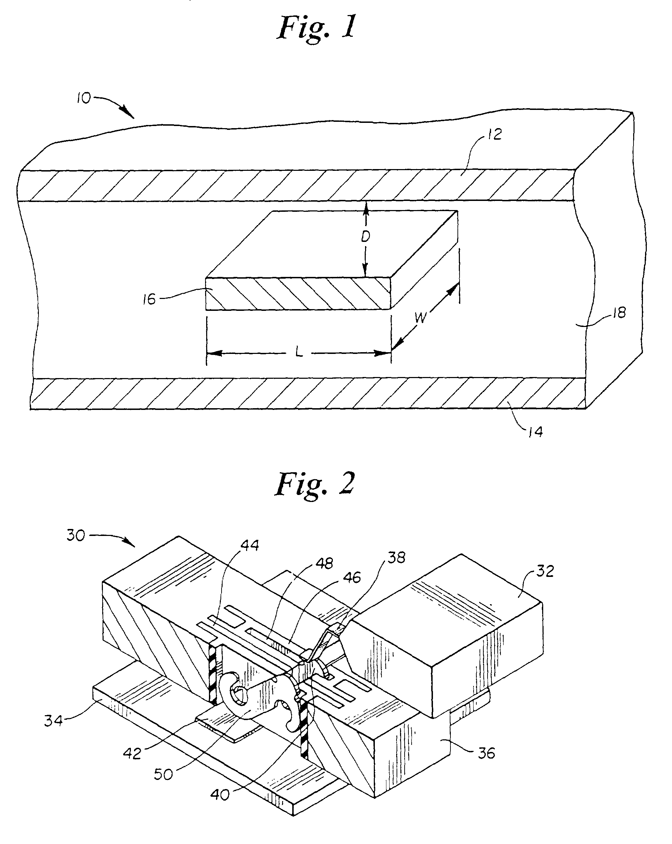

**Figure 1** is a fragmentary perspective view showing a conductor between two parallel plates. The diagram is generally shown at 10. **Figure 1** generally shows the relationship between the physical characteristics of an electrical contact structure and the resulting impedance. A first plate 12 and a second plate 14 are shown extending substantially parallel to one another. A center plate 16 is disposed therebetween, wherein a dielectric or insulating material 18 is provided between the center plate 16 and the first and second plates 12, and 14.

For purposes of this discussion, it is assumed that center plate 16 is centered between first plate 12 and second plate 14. Thus, center plate 16 is positioned a distance "d" from first plate 12 and a same distance "d" from second plate 14. Center plate 16 has a length of "1" and a width of "w" as shown. Center plate 16, thus, has an area equal to "w" times "1". The capacitance between center plate 16 and first plate 12 is generally given by the formula:$\text{C = ε • A / D}$ wherein A is the area of center plate 16, D is the distance between center plate 16 and first plate 12, and ε is the permittivity of dielectric 18. A similar formula can be found for the capacitance between center plate 16 and second plate 14. The corresponding impedance is generally expressed by the formula:$\text{Z = 1 / (2πfC)}$ where f is the frequency.

It can readily be seen that the impedance can be affected by varying the area of center plate 16, the distance between center plate 16 and first plate 12 and/or second plate 14, and the permittivity of dielectric material 18.

**Figure 2** is a perspective view with some parts cut away showing a first embodiment of the present invention in combination with an integrated circuit 32 and a printed circuit board 34. The drawing is generally shown at 30. Integrated circuit 32 has a lead 38 which may electrically engage an S-shaped contact element 40. A lower portion (not shown) of S-shaped contact element 40 may electrically engage a terminal 42 of printed circuit board 34. The S-shaped contact element 40 is disposed within a slot within a housing 36. The construction of the S-shaped contact and the corresponding housing assembly 36 are described in U.S. Patent No. 5,069,629, issued to Johnson on December 3, 1991. Although not specifically shown, it is contemplated that any size, shape or type of contact element may be used in conjunction with the present invention. This includes both rigid planer contact elements, deformable contact elements, or any other type of contact elements.

In the first embodiment of the present invention, housing 36 is manufactured from a conductive material such as aluminum. It is recognized, however, that housing 36 may be made from any conductive material. Housing 36 has a number of slots disposed therein, thereby forming a number of ribs therebetween. One such rib is shown at 44. In a preferred embodiment, the aluminum housing is manufactured from an aluminum blank. Each of the number of slots may be formed using an electro-discharge machining (EDM) process or a laser cutting process.

A sleeve 46 may be disposed in predetermined ones of the slots of housing 36. Each sleeve 46 may be manufactured from a dielectric or insulating material such as polytetrafluoroethylene. Polytetrafluoroethylene is sold under the registered trademark "TEFLON®" by Dupont Corporation. It is recognized, however, that any insulating material may be used to achieve the benefits of the present invention. It is further recognized that a user may select an insulating material which has a desired permittivity value, thereby providing the desired impedance characteristics to a corresponding contact element. It is contemplated that the sleeves may be constructed as separate elements, or may be an electrically insulative coating placed on the housing 36.

Each sleeve 46 may have a slot formed therein for receiving a corresponding contact. For example, sleeve 46 may have a slot 48 formed therein. Contact 40 may be disposed within slot 48 such that lead 38 may electrically engage an upper portion of contact 40 while terminal 42 may electrically engage a lower portion (not shown) of contact 40. Contact 40 may engage at least one elastomeric element as described in U.S. Patent No. 5,069,629, issued to Johnson on December 3, 1991.

Sleeve 46 may provide electrical isolation between contact 40 and housing 36. Further, sleeve 46 may be replaceable. This may be particularly useful after a predetermined amount of wear occurs between the sleeve 46 and contact 40 due to friction and other damage mechanisms.

Since housing 36 may be made from a conductive material, housing 36 may provide EMI shielding to contact 40. Further, it is contemplated that housing 36 may shield integrated circuit 32 from noise generated on, or by, traces on printed circuit board 34. Finally, rib 44 of housing 36 may minimize crosstalk between contact 40 and an adjacent contact 50.

It is contemplated that housing 36 may be grounded or otherwise electrically connected to a known voltage. In this configuration, the contact is surrounded by metal and an intervening dielectric, thereby yielding a strip-line structure. The geometries and certain other physical parameters thus define the impedance of the contact elements.

In another embodiment of the present invention, housing 36 may be formed from a plastic or other suitable dielectric or insulating material. Predetermined portions of housing 36 may then be coated or otherwise provided with a conductive surface. In a preferred embodiment, the inner surfaces of the ribs of housing 36 may be coated to minimize cross-talk between adjacent contacts. Further, it is contemplate that the top and side surfaces of housing 36 may be similarly coated to provide a shielding function. The conductive coating may be electrically coupled to ground.

An advantage of the embodiment shown in **Figure 2** is that the impedance of contact 40 is known and stabilized. In some prior art interconnect systems, the impedance of contact 40 may be dominated by stray capacitance and stray inductance, which may not terminate to a known voltage. The embodiment shown in **Figure 2** provides a ground plane and thus a majority of the impedance is terminated to ground. This may stabilize the bandpass of each contact up to the cutoff frequency thereof.

With reference to **Figure 1** and **Figure 2**, housing 36 provides a first plate (or rib) 44 and a second plate (or housing) 36, with contact 40 disposed therebetween. The impedance, as seen by contact 40, is defined by the area of contact 40, the distance between contact 40 and rib 44 and housing 36, and the permittivity of sleeve 46. By varying these parameters, the impedance of contact 40 may be designed to match, or correct for, the input impedance of the corresponding input of integrated circuit device 32. In an illustrative embodiment, the distance between contact 40 and rib 44 is approximately 17 mils, but other distances are contemplated.

As indicated in U.S. Patent No. 5,069,629, issued to Johnson, contact 40 is easily field replaceable. That is, each contact 40 may be removed and replaced with another contact. Thus, it is contemplated that a number of contacts, each having a different area, may be provided to a user along with a housing. The user may determine the input impedance of each input of a corresponding integrated circuit. The user may then provide an appropriate contact into each slot within housing 36 such that the impedance of each contact may match, or correct for, the input impedance of the corresponding inputs of the integrated circuit device. Thus, the user may: (1) determine the desired impedance of a contact element; (2) select a contact element that will result in the desired impedance; and (3) provide the contact selected in step (2) into a corresponding slot within a housing. In this way, a user may program the impedance of each contact within the interconnect device for each integrated circuit input to be tested.

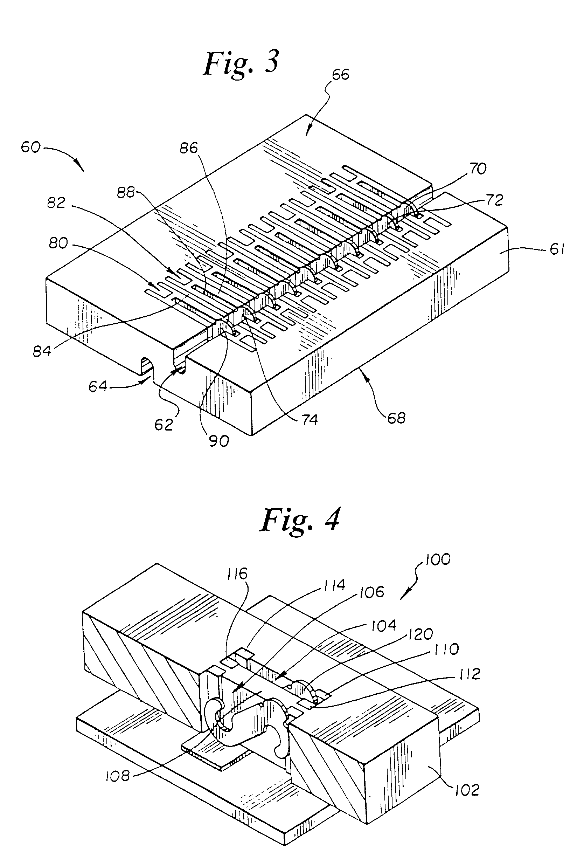

**Figure 3** is a perspective view showing a housing in accordance with the first embodiment of the present invention. The drawing is generally shown at 60. A housing 61 comprising an electrically conductive material is provided. In a preferred embodiment, housing 61 is manufactured from aluminum, but it is recognized that any conductive material may achieve similar results. Housing 61 may have a top surface 66 and a bottom surface 68 as shown. A number of slots, for example slots 80,82, may be formed though housing 61. Each of the slots 80,82 may extend from the top surface 66 through housing 61 to the bottom surface 68. As a result of forming the number of slots 80,82, a number of ribs may remain. For example, rib 84 may extend between slots 80 and 82. Each rib 84 may be electro-mechanically coupled to housing 61, thereby providing an electrical shield around the perimeter of slots 80 and 82.

A sleeve may be provided within each of the slots. For example, sleeve 86 may be provided in slot 82. It is contemplated that sleeve 86 may be manufactured from an insulating or dielectric material such as polytetrafluoroethylene. Each sleeve may have a slot formed therein for receiving a corresponding contact element. For example, sleeve 86 may have slot 88 formed therein for receiving a corresponding contact element.

A contact may then be provided in each slot of predetermined sleeves. For example, contact 74 may be provided within slot 88 of sleeve 86. In this configuration, sleeve 86 may electrically isolate contact 74 from housing 61. As indicated above, housing 61 may be electrically coupled to ground or to some other known voltage. Since housing 61 is made from a conductive material, housing 61 may provide EMI shielding to each of the contacts as shown. Further, the ribs of housing 61 may minimize crosstalk between adjacent contacts. Although not specifically shown, it is contemplated that any size, shape or type of contact element may be used in conjunction with the present invention. This includes both rigid planar contact elements, deformable contact elements, or any other type of contact elements.

Referring specifically to housing 61, a first trough 62 may be provided in the top surface 66 thereof extending in a downward direction therefrom. A second trough 64 may be provided in the bottom surface 68 thereof extending in an upward direction therefrom, wherein the first trough 62 is laterally offset from the second trough 64. A first support element (not shown) may be disposed in the first trough 62 and a second support element (not shown) may be disposed in the second trough 64. The first and second support elements may be made from a rigid or elastomeric material. Each of the number of contacts may engage the first and second support members. A further discussion of the contact support structure may be found in U.S. Patent No. 5,069,629, issued to Johnson on December 3, 1991.

In a preferred embodiment, one or both of the first and second support elements (not shown) are made from an elastomeric material. This allows each of the contact elements to move both laterally and vertically when engaged by a device lead. The movement of the contacts may provide a wiping action to both the leads of an integrated circuit and the terminals of a printed circuit board. The embodiment shown in Figure 3 allows the desired contact motion while maintaining a relatively constant impedance.

The embodiment shown in **Figure 3** has the advantage that the impedance of each contact may be known and stabilized as described with reference to **Figure 2.** Thus, it is contemplated that a number of contacts, each having a different area, may be provided to a user. The user may determine the input impedance of each input of a corresponding integrated circuit. The user may then select and provide an appropriate contact into each slot within housing 61 such that the impedance of each contact may match, or correct for, the input impedance of the corresponding inputs of the integrated circuit device. Thus, the user may: (1) determine the desired impedance of a contact element; (2) select a contact element that will result in the desired impedance; and (3) provide the contact selected in step (2) into a corresponding slot within a housing. In this way, a user may program the impedance of each contact within the interconnect device for each integrated circuit input to be tested.

**Figure 4** is a perspective view with some parts cut away showing a second embodiment of the present invention in combination with a printed circuit board. The diagram is generally shown at 100. A housing 102 is provided. It is contemplated that housing 102 may be formed from an electrically conductive material. Although aluminum is the preferred material, it is recognized that any electrically conductive material may achieve similar results. Housing 102 may have a number of slots 104,106 formed therein. Each slot 104 and 106 may be separated by a rib 108. Rib 108 may be electro-mechanically coupled to housing 102. Each slot may have at least one spacing member 110 disposed therein. In the embodiment shown in **Figure 4**, slot 104 has four spacing members 110, 112, 114, and 116 disposed therein. Each of the four spacing members 110, 112, 114, and 116 may be positioned in one of the four corners of slot 104. Thus, spacing member 110 is laterally spaced from spacing member 112. Similarly, spacing member 114 is laterally spaced from spacing member 116. In a preferred embodiment, spacing members 110, 112, 114, and 116 may be formed from polytetrafluoroethylene. It is recognized, however, that a user may select an insulating material which has a desired permittivity thereby providing the desired impedance characteristics to a corresponding contact element.

A contact 120 may be provided within slot 104 such that an upper portion of contact 120 is positioned between spacing members 110 and 112, and a lower portion of contact 120 is positioned between spacing members 114 and 116. In this configuration, contact 120 is prevented from electrically contacted a sidewall of slot 104. Furthermore, the dielectric material extending between contact 120 and rib 108 and housing 102 is substantially comprised of air, except for the portions of contact 120 which engage spacing members 110, 112, 114, and 116. It is known that air has a low permittivity value and therefore may minimize the capacitance between contact 120 and rib 108 and housing 102. This may increase the bandpass and/or cut-off frequency of contact 120.

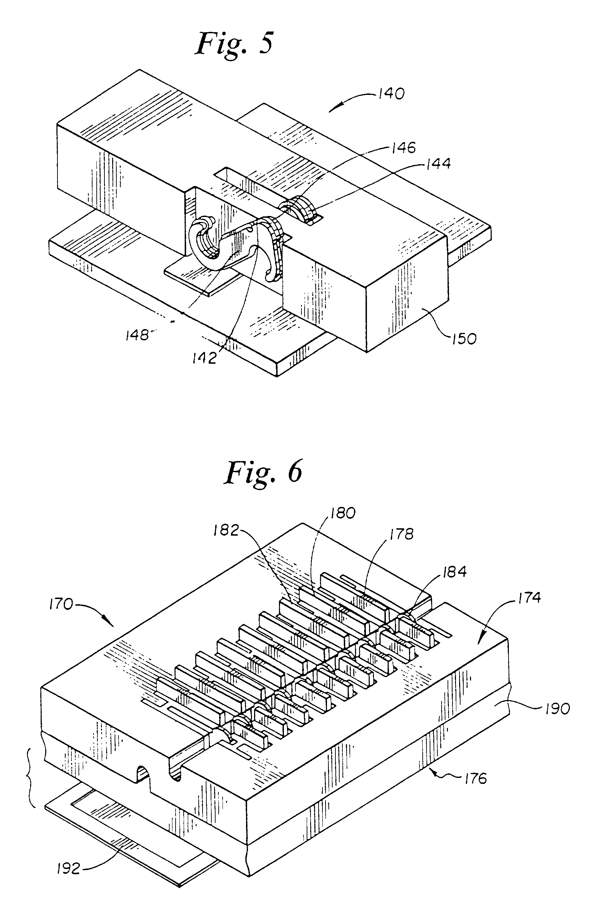

**Figure 5** is a perspective view with some parts cut away showing a third embodiment of the present invention in combination with a printed circuit board. The drawing is shown generally at 140. This embodiment is similar to the embodiment shown in **Figure 4** except the spacing members 110, 112, 114, and 116 are removed. Rather, each contact 142 and 144 may have an insulating layer provided directly on the lateral outer surfaces thereof. For example, contact 142 may have a first insulating layer 146 provided on a first surface thereof and a second insulating layer 148 on a second surface thereof. It is contemplated that the first and second insulating layers 146 and 148 may be provided on contact 142 via an adhesive, a deposition process, a subtractive process, or any other means. The first insulating layer 146 and the second insulating layer 148 may prevent contact 146 from electrically contacting housing 150. The same attendant advantages discussed above may be provided by this embodiment as well.

**Figure 6** is a perspective view showing a housing in accordance with a fourth embodiment of the present invention. The diagram is generally shown at 170. This embodiment is related to the first embodiment shown and describe with reference to **Figure 3.** However, in this embodiment, it is contemplated that preselected ribs of the housing may extend upward beyond the top surface of the housing and toward a corresponding integrated circuit device as shown. For example, ribs 178, 180, and 182 may extend above top surface 174 of housing 172. As indicated above with reference to **Figure 2**, a lead of an integrated circuit may electro-mechanically engage each of the contacts. For example, a lead of an integrated circuit may electro-mechanically engage contact 184. Thus, the lead of the integrated circuit may pass in between ribs 180 and 182. Ribs 180 and 182 may thus provide electro-magnetic shielding to the top portion of contact 184 and to at least a portion of the corresponding lead (not shown). Further, the impedance matching effects discussed above may be applied to both the contact 184 and the corresponding lead (not shown).

Another feature of the embodiment shown in **Figure 6** is an EMI skirt provided along the bottom perimeter of housing 172. It is contemplated that a skirt 190 may be provided between housing 172 and a corresponding printed circuit board. Skirt 190 may be formed from any conductive material. However, in a preferred embodiment, skirt 190 may be formed from a wire mesh which may be compressed as housing 172 is brought into engagement with a corresponding printed circuit board (not shown). Skirt 190 may provide EMI shielding to the lower portion of the contacts and/or the terminals on the printed circuit board.

Another feature of the embodiment shown in **Figure 6** is a conductive gasket 192. It is contemplated that conductive gasket 192 may be provided between housing 172 and a corresponding printed circuit board. Conductive gasket 192 may be formed from any conductive material. In a preferred embodiment, however, conductive gasket 192 may be formed from a metallic material or a wire mesh. Conductive gasket 192 may provide EMI shielding to the lower portion of the contacts and/or the terminals on the printed circuit board. It is contemplate that skirt 190 and conductive gasket 192 may be used together or individually, depending on the particular application.

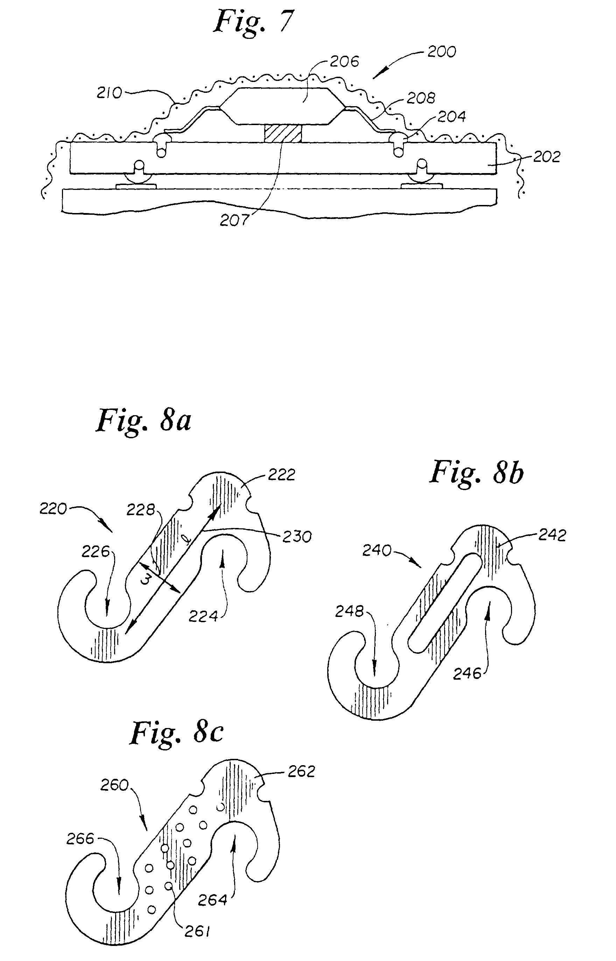

**Figure 7** is a side elevational view showing a housing in accordance with the first embodiment of the present invention with a wire mesh placed over the top surface thereof. The diagram is generally shown at 200. A housing 202 may be provided, wherein the housing may be made from a conductive material such as aluminum. It is recognized, however, that any conductive material may be used for housing 202.

As described with reference to **Figure 3,** a number of contacts, for example contact 204, may be received within a number of slots. A sleeve may be provided in each of the number of slots within the housing 202. The construction of the contact, sleeve, and housing is further described with reference to **Figure 3**.

An integrated circuit device 206 having a number of leads, may be brought into electro-mechanical engagement with the number of contacts of the interconnect device. For example, lead 208 of integrated circuit device 206 may be brought into electro-mechanical engagement with contact 204 of the interconnect device. The lower portion of selected contacts may be in electro-mechanical engagement with selected terminals on a printed circuit board. Thus, the interconnect device 200 may electro-mechanically couple a lead of integrated circuit device 206 with a corresponding terminal on a printed circuit board.

It is contemplated that an offset 207 may be positioned between housing 202 and integrated circuit device 206. In a preferred embodiment, offset 207 may be part of housing 202 and may be made from a conductive material. Since housing 202 may be grounded, offset 207 may provide a direct ground connection to integrated circuit device 206. This may be particularly useful when integrated circuit device 206 is packaged such that a ground plane thereof is positioned adjacent offset 207. Further, offset 207 may provide a thermal sink to integrated circuit device 206. Finally, offset 207 may provide a body stop to prevent damage to the leads 208 of integrated circuit 206 and to contacts 204.

In the embodiment shown in **Figure 7**, a conductive mesh 210 may be provided over the top of integrated circuit device 206. The conductive mesh may be electrically connected to the outer periphery or other predefined portion of housing 202. It is contemplated that conductive mesh 210 may be a wire mesh. It is further contemplated that conductive mesh 210 may comprise a conductive cover or similar structure which is electrically coupled to housing 202. A purpose of conductive mesh 210 is to provide EMI shielding to the upper portion of the contacts, the leads of the integrated circuit device 206, and the integrated circuit device 206 itself.

The density of the wire mesh may vary depending on the particular application. For example, the density of the wire mesh may be lower if only relatively low frequency EMI is to be shielded. Conversely, the density of the wire mesh may be higher if relatively high frequency EMI is be shielded. Thus, the wire mesh may be designed to accommodate a wide variety of applications.

**Figure 8A** is a side perspective view of an S-shaped contact as used in the present invention. The diagram is generally shown at 220. In a preferred embodiment, a contact 222 is S-shaped and dimensioned such that a first hook portion 224 engages a first support member (not shown) and a second hook portion 226 engages a second support member (not shown). In a preferred embodiment, contact 222 is formed from a beryllium-copper alloy. A further discussion of the contact support structure may be found in U.S. Patent No. 5,069,629, issued to Johnson on December 3, 1991.

With reference to **Figure 1,** the capacitance of a contact element is generally given by the formula C = ε · A / D. The area of contact 222 is defined by a contact length 230 and a contact width 228. In a preferred embodiment, the contact 222 is dimensioned to maintain the position of the first and second hook portions 224, 226. This may be necessary to allow the first and second hook portions 224, 226 to physically engage the first and second support members (not shown). In one embodiment, this may be accomplished by substantially maintaining the contact length 230. Thus, it is contemplated that the impedance of the contact element 222 may be varied by reducing the contact width 228 or varying other design parameters of contact 222.

It is contemplated that a number of contacts, each having a different area as described above, may be provided to a user. The user may determine the input impedance of each input of a corresponding integrated circuit. The user may then provide an appropriate contact into each slot within a housing such that the impedance of each contact may match, or correct for, the input impedance of the corresponding inputs of the integrated circuit device. Thus, the user may: (1) determine the desired impedance of a contact element; (2) select a contact element having the desired impedance; and (3) provide the contact selected in step (2) into a corresponding slot within a housing. In this way, a user may program the impedance of each contact within the interconnect device for each integrated circuit input to be tested.

It is further recognized that the distance from the contact to a corresponding rib may be varied to change the impedance of a corresponding contact. This may be accomplished by changing the thickness of the contact or providing a larger distance between adjacent ribs in the housing. Further, it is recognized that the permittivity of a corresponding sleeve may be varied by substituting various materials therefor to change the impedance of a corresponding contact. As indicated with reference to Figure 4, it has already been disclosed that air may be used as an insulating material. Other materials are also contemplated.

**Figure 8B** is a side perspective view of an S-shaped contact as used in the present invention with a predetermined portion removed therefrom. The diagram is generally shown at 240. A contact element 242 having a removed portion 244 may be provided. The removed portion 244 may reduce the overall area of contact element 242. As indicated with reference to **Figure 8A**, it is preferred that the position of the first and second hook portions 246 and 248 remain relatively fixed because the first and second hook portions 246, 248 must physically engage the first and second support members (not shown). In the embodiment shown in Figure 8B, the outer dimensions of contact element 242 are substantially the same as the outer dimensions of contact element 222 of Figure 8A. The impedance of contact element 242 may be varied by removing a predetermined portion of contact element 242 as shown. It is contemplated that any portion of contact element 242 may be removed as long as the position of the first and second hook portions 246, 248 remains relatively fixed.

**Figure 8C** is a side perspective view of an S-shaped contact as used in the present invention with a number of predetermined portions 261 removed therefrom. The diagram is generally shown at 260 wherein a contact element 262 is shown. This embodiment is similar to the structure shown in **Figure 8B**. However, rather than removing a single portion from the contact element, it is contemplated that a number of portions may be removed from contact element 262 as shown. This may reduce the overall area of contact element 262.

As indicated with reference to **Figure 8A,** it is preferred that the position of the first and second hook portions 264 and 266 remain relatively fixed because the first and second hook portions 264, 266 must physically engage the first and second support members (not shown). In the embodiment shown in Figure 8C, the outer dimensions of contact element 262 are substantially the same as the outer dimensions of contact elements 222 and 242. The impedance of the contact element 262 may be varied by removing a number of predetermined portions from contact element 262 as shown. It is contemplated that any number of portions may be removed from contact element 262 as long as the position of the first and second hook portions 264, 266 remains relatively fixed.

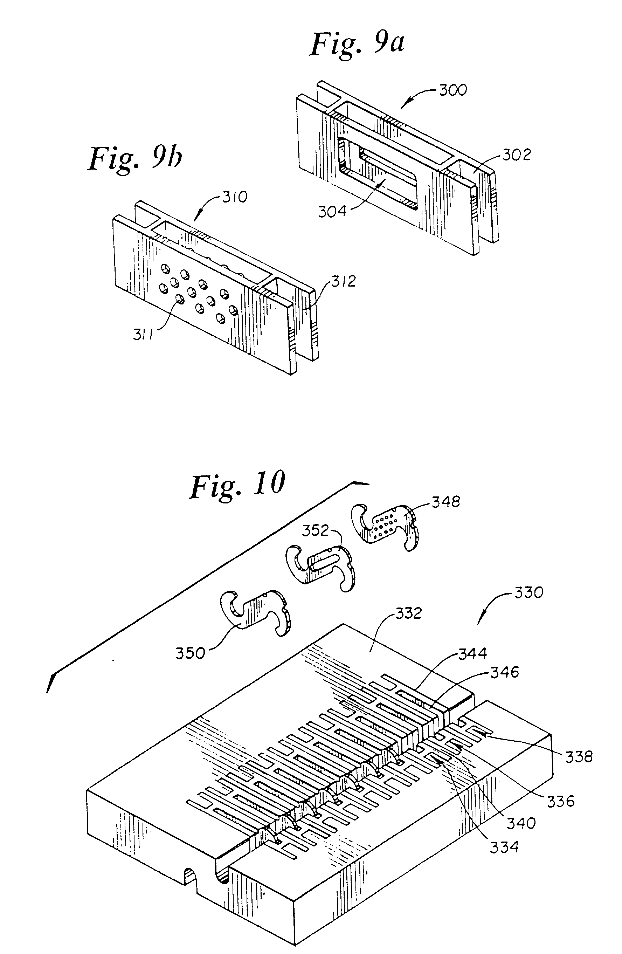

**Figure 9A** is a perspective view of a sleeve as used in the first embodiment of the present invention with a predetermined portion removed therefrom. The diagram is generally shown at 300. In a preferred embodiment, sleeve 302 is positioned within a corresponding slot within a housing. Since it is contemplated that the slots in the housing may be uniformly dimensioned, it is desired that each sleeve 302 have the same outer dimensions.

With reference to **Figure 1,** the capacitance of a contact element is given by the formula C = ε · A / D. The sleeve 302 may be made from an insulating material having a preselected permittivity. Thus, the impedance of a contact element may be varied by changing the permittivity of the dielectric or insulating material which is disposed between the contact element and the housing. In the embodiment shown in **Figure 9A,** a portion 304 may be removed from sleeve 302. Thus, the permittivity of the area between the contact element and the housing is defined by the insulating material for part of the contact area, and defined by air for the remaining contact area. By dimensioning the portion 304 that is removed from sleeve 302, a desired impedance may be selected for each contact in the interconnect device.

It is contemplated that'a number of sleeves, each having a different sized removed portion, may be provided to a user. The user may determine the input impedance of each pin of a corresponding integrated circuit. The user may then insert an appropriate sleeve into each slot of the housing such that the impedance of each contact may match, or correct for, the input impedance of the corresponding inputs of the integrated circuit device. Thus, the user may: (1) determine the desired impedance of a contact element; (2) select a sleeve that will result in the desired impedance; and (3) provide the sleeve selected in step (2) into a corresponding slot within a housing. In this way, a user may program the impedance of each contact within the interconnect device for each integrated circuit input to be tested.

**Figure 9B** is a perspective view of a sleeve as used in the first embodiment of the present invention with a number of predetermined portions removed therefrom. The diagram is generally shown at 310 wherein a sleeve 312 is shown. This embodiment is similar to **Figure 9A.** However, rather than removing a single portion from the sleeve, a number of predetermined portions 311 may be removed, as shown.

**Figure 10** is a perspective view showing a housing in accordance with the first embodiment of the present invention, wherein a number of S-shaped contacts having varying impedance characteristics are preselected and inserted within corresponding slots within the housing. The diagram is generally shown at 330. A housing 332 comprising an electrically conductive material is provided and is substantially similar to that shown and described with reference to **Figure 3.** A number of slots, for example slots 334,336, and 338, may be formed though housing 332. As a result of forming the number of slots 334,336, and 338, a number of ribs remain therebetween. For example, rib 340 may extend between slots 334 and 336. Each rib 340 is electro-mechanically coupled to housing 332, thereby providing an electrical shield around the perimeter of each of the slots.

A number of sleeves may be provided within each of the slots. For example, sleeve 344 may be provided in slot 338. It is contemplated that sleeve 344 may be manufactured from an insulating or dielectric material. Each sleeve may have a slot formed therein for receiving a corresponding contact element. For example, sleeve 344 may have slot 346 formed therein for receiving a corresponding contact element 348.

A preselected contact may then be provided within each of the slots of the number of sleeves. For example, contact 348 may be provided within slot 346 of sleeve 344. In this configuration, sleeve 344 electrically isolates contact 346 from housing 332. In a preferred embodiment, housing 332 is electrically coupled to ground or to some other known voltage. Since housing 332 is made from a conductive material, housing 332 may provide EMI shielding to each of the contacts therein. Further, the ribs of housing 332 may minimize crosstalk between adjacent contacts.

Referring specifically to the embodiment shown in **Figure 10**, it is contemplated that a number of contacts 348,350,352, each having a different area and thus a different impedance characteristic, may be provided to a user of the interconnect device. The user may determine the input impedance of each input of a corresponding integrated circuit. The user may then provide an appropriate contact, as shown, into each slot within housing 332 such that the impedance of each contact may match, or correct for, the input impedance of the corresponding inputs of the integrated circuit device. Thus, the user may: (1) determine the desired impedance of a contact element; (2) select a contact element that will result in the desired impedance; and (3) provide the contact selected in step (2) into a corresponding slot within the housing. In this way, a user may program the impedance of each contact within the interconnect device for each integrated circuit input to be tested.

It is further contemplate that the user may: (1) determine the desired impedance of a contact element; (2) select a sleeve that will result in the desired impedance; and (3) provide the sleeve selected in step (2) into a corresponding slot within a housing. In this way, a user may program the impedance of each contact within the interconnect device for each integrated circuit input to be tested.

Finally, it is contemplated that a user may: (1) determine the desired impedance of a contact element; (2) select a sleeve and contact combination that will result in the desired impedance; and (3) provide the sleeve and contact combination selected in step (2) into a corresponding slot within a housing. This may provide additional flexibility in achieving the desired contact impedance.

New characteristics and advantages of the invention covered by this document have been set forth in the foregoing description. It will be understood, however, that this disclosure is, in many respects, only illustrative. Changes may be made in details, particularly in matters of shape, size, and arrangement of parts, without exceeding the scope of the invention. The scope of the invention is, of course, defined in the language in which the appended claims are expressed.

## Claims

1. Apparatus for electrically interconnecting a first terminal to a second terminal, comprising:
(a) a housing (61;102) having at least a portion which is electrically conductive, said housing having a number of slots (80, 82) formed therein;
(b) a sleeve (86) provided in a preselected one of said number of slots of said housing and having a portion which is electrically insulative, said sleeve forming a contact receiving slot (88); and
(c) a contact (74) disposed in said contact receiving slot formed by said sleeve, at least a portion of said contact being electrically conductive, and said sleeve electrically insulating the portion of said contact that is electrically conductive from the portion of said housing that is electrically conductive;
(d) whereby when said first terminal and said second terminal engage said contact, said contact electrically connects said first terminal to said second terminal.

2. Apparatus according to claim 1 wherein said housing (61) has an outer surface (66, 68) and a portion of said outer surface is formed from a conductive material.

3. Apparatus according to claim 2 wherein said entire housing (61, 102) is formed from a conductive material.

4. Apparatus according to any one of claims 1 to 3 wherein said sleeve (86) is of a singular construction.

5. Apparatus according to anyone of claims 1 to 3 claim 1 wherein said sleeve (86) comprises a number of spacing members.

6. Apparatus according to any one of claims 1 to 5 wherein said contact (74) has a number of holes (261) therein.

7. Apparatus according to any one of claims 1 to 6 wherein said housing (102) includes a first slot (104) and a second slot (106), and the first slot is located adjacent to the second slot with a rib (108) extending therebetween.

8. Apparatus according to claim 7 wherein at least a portion of said rib (108) is electrically conductive.

9. Apparatus according to claim 8 wherein said portion of said rib (108) that is electrically conductive is electrically coupled to said housing (102).

10. Apparatus according to claim 9 wherein said rib (108) has a first surface forming part of said first slot (104) and a second surface forming part of said second slot (106).

11. Apparatus according to claim 10 wherein at least a portion of said first surface of said rib (108) is electrically conductive.

12. Apparatus according to claim 10 wherein at least a portion of said first surface of said rib (108) is coated with a conductive material.

13. Apparatus according to claim 11 wherein at least a portion of said second surface of said rib (108) is electrically conductive.

14. Apparatus according to claim 13 wherein at least a portion of said second surface of said rib (108) is coated with a conductive material.

15. Apparatus according to any one of claims 1 to 14 wherein said sleeve (86) includes a number of holes extending through a portion thereof, wherein said number of holes are positioned generally between said housing and said contact.

16. Apparatus according to any one of claims 7 to 15 wherein said housing (102) has a top surface and a bottom surface, and said first and second slots (104,106) extend between said top surface and said bottom surface.

17. Apparatus according to claim 16 wherein said rib (178, 180, 182) extends beyond the said top surface of said housing (102).

18. Apparatus according to any one of claims 1 to 17 further comprising an electrically conductive skirt (190), provided along a bottom perimeter of said housing (172) and electrically coupled to said housing (172).

19. Apparatus according to claim 18 wherein said conductive skirt (109) is electrically coupled to said housing (172) and extends above said top surface of said housing.

20. A method for configuring an interconnect apparatus, wherein the interconnect apparatus includes a housing (61), at least a portion of the housing being electrically conductive, a number of sleeves (86), a portion of the sleeve being electrically insulative and a number of contacts (74), at least a portion of said contact being electrically conductive, the housing having a number of contact locations in the form of contact receiving slots (80,82), wherein at least one of the number of sleeves is mounted at selected ones of the number of contact locations, and at least one of the number of contacts (74) is mounted in corresponding ones of the number of sleeves (86), the method comprises the steps of;
(a) providing a number of sleeves wherein each of the number of sleeves provides a different impedance between a corresponding contact and the housing when mounted in a selected one of the number of contact locations of the housing;
(b) determining a desired impedance for selected ones of the number of contact locations of the housing;
(c) selecting a sleeve from the number of sleeves that provides the desired impedance for each of the contact locations of the housing; and
(d) mounting the selected sleeves into the corresponding contact locations of the housing, and mounting at least one contact in each of the selected sleeves.

21. A method for electrically interconnecting a first terminal to a second terminal, comprising the steps of :
- positioning an apparatus as in any of claims 1 to 17 between said first and second terminals;
- engaging said first and second terminals with said contact (74) located in the contact receiving slot of the housing (61;102) of said apparatus.

22. A method as in claim 21, further comprising the step of providing an electrically conductive skirt (190) along a bottom perimeter of said housing (172), said skirt being provided between said housing (172) and said second terminal.

23. A method as in any of claims 21 or 22, further comprising the step of providing an electrically conductive gasket (192) electrically coupled to said housing (172) and extending from a bottom surface of said housing toward said second terminal.

24. A method as in any of claims 21 to 23, wherein said second terminal is a conductive pad on a printed circuit board.

25. A method as in any of claims 21 to 23, said second terminal being a device lead of a device package.

26. A method as in any of claims 21 to 25, further comprising the step of providing said apparatus with a conductive skirt (190) electrically coupled to said housing (172) and extending above a top surface of said housing toward said first terminal.

## Patentansprüche

1. Vorrichtung zum elektrischen Verbinden eines ersten Anschlusses mit einem zweiten Anschluß, wobei die Vorrichtung folgendes aufweist:
(a) ein Gehäuse (61; 102), das wenigstens zum Teil elektrisch leitfähig ist, wobei in dem Gehäuse eine Anzahl von Schlitzen (80, 82) ausgebildet ist;
(b) eine Hülse (86), die in einem vorgewählten der Anzahl von Schlitzen des Gehäuses angeordnet ist und einen elektrisch isolierenden Teil aufweist, wobei die Hülse einen Kontaktaufnahmeschlitz (88) bildet; und
(c) einen Kontakt (74), der in dem durch die Hülse gebildeten Kontaktaufnahmeschlitz angeordnet ist, wobei wenigstens ein Teil des Kontakts elektrisch leitfähig ist und wobei die Hülse den elektrisch leitfähigen Teil des Kontakts von dem elektrisch leitfähigen Teil des Gehäuses elektrisch isoliert;
(d) wodurch dann, wenn der erste Anschluß und der zweite Anschluß mit dem Kontakt in Eingriff treten, der Kontakt den ersten Anschluß mit dem zweiten Anschluß elektrisch verbindet.

2. Vorrichtung nach Anspruch 1,
wobei das Gehäuse (61) eine äußere Oberfläche (66, 68) aufweist und ein Teil der äußeren Oberfläche aus einem leitfähigen Material gebildet ist.

3. Vorrichtung nach Anspruch 2,
wobei das gesamte Gehäuse (61; 102) aus einem leitfähigen Material gebildet ist.

4. Vorrichtung nach einem der Ansprüche 1 bis 3,
wobei die Hülse (86) eine einstückige Konstruktion besitzt.

5. Vorrichtung nach einem der Ansprüche 1 bis 3,
wobei die Hülse (86) eine Anzahl von Abstandselementen aufweist.

6. Vorrichtung nach einem der Ansprüche 1 bis 5,
wobei der Kontakt (74) eine Anzahl von Öffnungen (261) aufweist.

7. Vorrichtung nach einem der Ansprüche 1 bis 6,
wobei das Gehäuse (102) einen ersten Schlitz (104) und einen zweiten Schlitz (106) aufweist und der erste Schlitz dem zweiten Schlitz unter Zwischenanordnung einer Rippe (108) benachbart angeordnet ist.

8. Vorrichtung nach Anspruch 7,
wobei wenigstens ein Teil der Rippe (108) elektrisch leitfähig ist.

9. Vorrichtung nach Anspruch 8,
wobei der elektrisch leitfähige Teil der Rippe (108) mit dem Gehäuse (102) elektrisch gekoppelt ist.

10. Vorrichtung nach Anspruch 9,
wobei die Rippe (108) eine erste Oberfläche, die Teil des ersten Schlitzes (104) bildet, und eine zweite Oberfläche aufweist, die Teil des zweiten Schlitzes (106) bildet.

11. Vorrichtung nach Anspruch 10,
wobei wenigstens ein Teil der ersten Oberfläche der Rippe (108) elektrisch leitfähig ist.

12. Vorrichtung nach Anspruch 10,
wobei wenigstens ein Teil der ersten Oberfläche der Rippe (108) mit einem leitfähigen Material beschichtet ist.

13. Vorrichtung nach Anspruch 11,
wobei wenigstens ein Teil der zweiten Oberfläche der Rippe (108) elektrisch leitfähig ist.

14. Vorrichtung nach Anspruch 13,
wobei wenigstens ein Teil der zweiten Oberfläche der Rippe (108) mit einem leitfähigen Material beschichtet ist.

15. Vorrichtung nach einem der Ansprüche 1 bis 14,
wobei die Hülse (86) eine Anzahl von Öffnungen aufweist, die sich durch einen Teil derselben hindurch erstrecken, wobei die Anzahl der Öffnungen im wesentlichen zwischen dem Gehäuse und dem Kontakt angeordnet ist.

16. Vorrichtung nach einem der Ansprüche 7 bis 15,
wobei das Gehäuse (102) eine obere Oberfläche und eine untere Oberfläche aufweist und sich der erste und der zweite Schlitz (104, 106) zwischen der oberen und der unteren Oberfläche erstrecken.

17. Vorrichtung nach Anspruch 16,
wobei sich die Rippe (178, 108, 182) über die obere Oberfläche des Gehäuses (102) hinaus erstreckt.

18. Vorrichtung nach einem der Ansprüche 1 bis 17,
weiterhin mit einem elektrisch leitfähigen Sockel (190), der entlang einer unteren Begrenzungsfläche des Gehäuses (172) vorgesehen ist und mit dem Gehäuse (172) elektrisch gekoppelt ist.

19. Vorrichtung nach Anspruch 18,
wobei der leitfähige Sockel (109) mit dem Gehäuse (172) elektrisch gekoppelt ist und sich über der oberen Oberfläche des Gehäuses erstreckt.

20. Verfahren zum Konfigurieren einer Zwischenverbindungsvorrichtung, wobei die Zwischenverbindungsvorrichtung folgendes aufweist: ein Gehäuse (61), das wenigstens zum Teil elektrisch leitfähig ist, eine Anzahl von Hülsen (86), die einen elektrisch isolierenden Teil aufweisen, und eine Anzahl von Kontakten (74), die einen elektrisch leitfähigen Teil aufweisen, wobei das Gehäuse eine Anzahl von Kontaktpositionen in Form von Kontaktaufnahmeschlitzen (80, 82) aufweist wobei wenigstens eine der Anzahl von Hülsen an ausgewählten der Anzahl von Kontaktpositionen angebracht wird und wenigstens einer der Anzahl von Kontakten (74) in entsprechenden der Anzahl von Hülsen (86) angebracht wird,
wobei das Verfahren folgende Schritte aufweist:
(a) Vorsehen einer Anzahl von Hülse, wobei jede der Anzahl von Hülsen bei Montage in einer ausgewählten der Anzahl von Kontaktpositionen des Gehäuses eine andere Impedanz zwischen einem entsprechenden Kontakt und dem Gehäuse schafft;
(b) Bestimmen einer gewünschten Impedanz für ausgewählte der Anzahl von Kontaktpositionen des Gehäuses;
(c) Auswählen einer Hülse aus der Anzahl von Hülsen, die die gewünschte Impedanz für jede der Kontaktpositionen des Gehäuses schafft; und
(d) Anbringen der ausgewählten Hülsen in den entsprechenden Kontaktpositionen des Gehäuses und Anbringen von wenigstens einem Kontakt in jeder der ausgewählten Hülsen.

21. Verfahren zum elektrischen Verbinden eines ersten Anschlusses mit einem zweiten Anschluß, das folgende Schritte aufweist:
- Positionieren einer Vorrichtung nach einem der Ansprüche 1 bis 17 zwischen dem ersten und dem zweiten Anschluß;
- in Eingriff Bringen des ersten und des zweiten Anschlusses mit dem Kontakt (74), der in dem Kontaktaufnahmeschlitz des Gehäuses (61; 102) der Vorrichtung angeordnet ist.

22. Verfahren nach Anspruch 21,
bei dem ferner ein elektrisch leitfähiger Sockel (190) entlang einer unteren Begrenzungsfläche des Gehäuses (172) vorgesehen wird, wobei der Sockel zwischen dem Gehäuse (172) und dem zweiten Anschluß vorgesehen wird.

23. Verfahren nach Anspruch 21 oder 22,
bei dem ferner eine elektrisch leitfähige Dichtung (192) vorgesehen wird, die mit dem Gehäuse (172) elektrisch gekoppelt wird und sich von einer Bodenfläche des Gehäuses weg in Richtung auf den zweiten Anschluß erstreckt.

24. Verfahren nach einem der Ansprüche 21 bis 23,
wobei der zweite Anschluß eine leitfähige Anschlußfläche auf einer gedruckten Schaltungsplatte ist.

25. Verfahren nach einem der Ansprüche 21 bis 23,
wobei der zweite Anschluß eine Vorrichtungsleitung eines Vorrichtungsbausteins ist.

26. Verfahren nach einem der Ansprüche 21 bis 25,
wobei ferner ein leitfähiger Sockel (190) vorgesehen wird, der mit dem Gehäuse (172) elektrisch gekoppelt wird und sich über einer oberen Oberfläche des Gehäuses in Richtung auf den ersten Anschluß erstreckt.

## Revendications

1. Appareil permettant d'interconnecter électriquement une première borne à une deuxième borne, l'appareil comprenant :
(a) un logement (61; 102) possédant au moins une partie qui est électriquement conductrice, ledit logement comportant un certain nombre de fentes (80, 82) qui y sont formées ;
(b) un manchon (86) disposé dans l'une, présélectionnée, desdites fentes dudit logement et comportant une partie qui est électriquement isolante, ledit manchon formant une fente (88) de réception de contact ; et
(c) un contact (74) disposé dans ladite fente de réception de contact qui est formée par ledit manchon, au moins une partie dudit contact étant électriquement conductrice, et ledit manchon isolant électriquement la partie dudit contact qui est électriquement conductrice de la partie dudit logement qui est électriquement conductrice ;
(d) si bien que, lorsque ladite première borne et ladite deuxième borne sont en contact avec ledit contact, ledit contact connecte électriquement ladite première borne à ladite deuxième borne.

2. Appareil selon la revendication 1, où ledit logement (61) possède une surface extérieure (66, 68), une partie de ladite surface extérieure étant formée en un matériau conducteur.

3. Appareil selon la revendication 2, où ledit logement tout entier (61 ; 102) est formé en un matériau conducteur.

4. Appareil selon l'une quelconque des revendications 1 à 3, où ledit manchon (86) est d'une construction singulière.

5. Appareil selon l'une quelconque des revendications 1 à 3, où ledit manchon (86) comprend un certain nombre d'éléments d'écartement.

6. Appareil selon l'une quelconque des revendications 1 à 5, où ledit contact (74) comporte un certain nombre de trous (261).

7. Appareil selon l'une quelconque des revendications 1 à 6, où ledit logement (102) comporte une première fente (104) et une deuxième fente (106), et la première fente est placée au voisinage de la deuxième fente, une nervure (108) s'étendant entre elles.

8. Appareil selon la revendication 7, où au moins une partie de ladite nervure (108) est électriquement conductrice.

9. Appareil selon la revendication 8, où ladite partie de ladite nervure (108) qui est électriquement conductrice est électriquement couplée audit logement (102).

10. Appareil selon la revendication 9, où ladite nervure (108) possède une première surface faisant partie de ladite première fente (104) et une deuxième surface faisant partie de ladite deuxième fente (106).

11. Appareil selon la revendication 10, où au moins une partie de ladite première surface de ladite nervure (108) est électriquement conductrice.

12. Appareil selon la revendication 10, où au moins une partie de ladite première surface de ladite nervure (108) est revêtue d'un matériau conducteur.

13. Appareil selon la revendication 11, où au moins une partie de ladite deuxième surface de ladite nervure (108) est électriquement conductrice.

14. Appareil selon la revendication 13, où au moins une partie de ladite deuxième surface de ladite nervure (108) est revêtue d'un matériau conducteur.

15. Appareil selon l'une quelconque des revendications 1 à 14, où ledit manchon (86) comporte un certain nombre de trous traversant une partie de celui-ci, où lesdits trous sont placés généralement entre ledit logement et ledit contact.

16. Appareil selon l'une quelconque des revendications 7 à 15, où ledit logement (102) possède une surface supérieure et une surface inférieure, et lesdites première et deuxième fentes (104, 106) s'étendent entre ladite surface supérieure et ladite surface inférieure.

17. Appareil selon la revendication 16, où ladite nervure (178, 180, 182) s'étend au-delà de ladite surface supérieure dudit logement (102).

18. Appareil selon l'une quelconque des revendications 1 à 17, comprenant en outre une bordure électriquement conductrice (190), disposée le long du périmètre inférieur dudit logement (172) et électriquement couplée audit logement (172).

19. Appareil selon la revendication 18, où ladite bordure conductrice (190) est électriquement couplée audit logement (172) et s'étend au-dessus de ladite surface supérieure dudit logement.

20. Procédé de configuration d'un appareil d'interconnexion, où l'appareil d'interconnexion comporte un logement (61), au moins une partie du logement étant électriquement conductrice, un certain nombre de manchons (86), une partie du manchon étant électriquement isolante, et un certain nombre de contacts (74), au moins une partie dudit contact étant électriquement conductrice, le logement possédant un certain nombre d'emplacements de contacts se présentant sous la forme de fentes (80, 82) de réception de contacts, où au moins un des manchons est monté au niveau d'emplacements sélectionnés parmi lesdits emplacements de contacts, et au moins l'un des contacts (74) est monté dans des manchons correspondants parmi les manchons (86), le procédé comprenant les opérations suivantes :
(a) prévoir un certain nombre de manchons, où chacun des manchons offre une impédance différente entre un contact correspondant et le logement lorsqu'il est monté dans l'un, sélectionné, des emplacements de contacts du logement ;
(b) déterminer une impédance voulue pour des emplacements sélectionnés parmi les emplacements de contacts du logement ;
(c) sélectionner parmi les manchons un manchon qui donne l'impédance voulue pour chacun des emplacements de contacts du logement ; et
(d) monter les manchons sélectionnés dans les emplacements de contacts correspondants du logement, et monter au moins un contact dans chacun des emplacements sélectionnés.

21. Procédé permettant d'interconnecter électriquement une première borne à une deuxième borne, comprenant les opérations suivantes :
placer un appareil selon l'une quelconque des revendications 1 à 17 entre lesdits premier et deuxième bornes ;
mettre lesdites première et deuxième bornes en contact avec ledit contact (74) placé dans la fente de réception de contact du logement (61 ; 102) dudit appareil.

22. Procédé selon la revendication 21, comprenant en outre l'opération qui consiste à placer une bordure électriquement conductrice (190) le long du périmètre inférieur du logement (172), ladite bordure étant placée entre ledit logement (172) et ladite deuxième borne.

23. Procédé selon l'une quelconque des revendications 21 et 22, comprenant en outre l'opération qui consiste à coupler électriquement une garniture électriquement conductrice (192) audit logement (172), la garniture s'étendant depuis une surface inférieure dudit logement en direction de ladite deuxième borne.

24. Procédé selon l'une quelconque des revendications 21 à 23, où ladite deuxième borne est un plot conducteur disposé sur une carte de circuit imprimé.

25. Procédé selon l'une quelconque des revendications 21 à 23, ladite deuxième borne étant un fil conducteur de dispositif d'un boîtier de dispositif.

26. Procédé selon l'une quelconque des revendications 21 à 25, comprenant en outre l'opération qui consiste à doter ledit appareil d'une bordure conductrice (190) électriquement couplée audit logement (172) et s'étendant au-dessus d'une surface supérieure dudit logement en direction de ladite première borne.
